# EUROPÄISCHE PATENTSCHRIFT

(11) **EP 3 025 567 B1**
(45) Veröffentlichungstag und Bekanntmachung des Hinweises auf die Patenterteilung: **26.04.2017**
(21) Anmeldenummer: 14733150.8
(22) Anmeldetag: 24.06.2014
(51) Int. Cl.: H05K 5/00, H01R 13/627

(54) **VERBINDUNGSANORDNUNG ZWISCHEN EINEM STEUERGERÄT UND EINER MIT DEM STEUERGERÄT VERBUNDENEN BAUEINHEIT**
CONNECTING ASSEMBLY BETWEEN A CONTROL DEVICE AND A MODULE CONNECTED TO THE CONTROL DEVICE
ENSEMBLE DE LIAISON ENTRE UN APPAREIL DE COMMANDE ET UNE UNITÉ MODULAIRE RELIÉE À L'APPAREIL DE COMMANDE

(30) Priorität: 26.07.2013 DE 102013214690
(43) Veröffentlichungstag der Anmeldung: 01.06.2016
(73) Patentinhaber: Robert Bosch GmbH, 70442 Stuttgart (DE)
(72) Erfinder: LISCHECK, Andre, 71665 Vaihingen/Enz (DE); KROECKEL, Markus, 71701 Schwieberdingen (DE); GEBERS, Joerg, 71282 Hemmingen (DE)
(86) Internationale Anmeldenummer: PCT/EP2014/063235
(87) Internationale Veröffentlichungsnummer: WO 2015/010844

(56) Entgegenhaltungen:
- EP-A1- 1 672 972
- JP-A- 2000 156 254

## Beschreibung

### Stand der Technik

Die Erfindung betrifft eine Verbindungsanordnung zwischen einem Steuergerät und einer mit dem Steuergerät verbundenen Baueinheit zur elektrischen Kontaktierung des Steuergeräts nach dem Oberbegriff des Anspruchs 1.

Eine Verbindungsanordnung nach dem Oberbegriff des Anspruchs 1 ist aus der DE 10 2010 002 947 A1 der Anmelderin bekannt. Sie umfasst einen Schaltungsträger, z.B. in Form einer Leiterplatte oder Ähnlichem, auf dem wenigstens eine Schaltungseinheit angeordnet ist, die über mit der Schaltungseinheit zumindest mittelbar verbundene Kontakteinheiten mittels einer anderen elektrischen Baueinheit (beispielsweise einem Kabelbaumstecker) elektrisch kontaktierbar ist. Wesentlich dabei ist, dass der Schaltungsträger, mit Ausnahme zumindest in den Bereichen, in denen die Kontakteinheiten mit der anderen elektrischen Baueinheit verbindbar sind, von einer Schutzmasse umgeben ist. Die Schutzmasse, die insbesondere aus Kunststoff besteht und die durch Vergießen des Schaltungsträgers oder Umspritzen mit einem duroplastischen Kunststoff (im Thermotransfer-Moulding-Verfahren) bildet eine Gehäuseeinheit aus. In der oben genannten Schrift sind verschiedene Möglichkeiten zur elektrischen Kontaktierung der Kontakteinheiten des Steuergeräts mittels unterschiedlich ausgebildeter elektrischer Baueinheiten dargestellt bzw. offenbart. Zum Einsatz kommen dabei insbesondere als klammerartige Konstruktionen ausgebildete Baueinheiten mit Federelementen als Kontaktelemente, die unter Ausbildung einer Vorspannkraft an den Kontakteinheiten anliegen. Weiterhin ist eine Rastverbindung zwischen den beiden halbschalenförmigen Elementen der Baueinheit vorgesehen. Wesentlich dabei ist, dass die erwähnte Baueinheit das Steuergerät vollständig umschließt und somit relativ viel Bauraum benötigt. Außerdem ist dadurch eine separate Befestigung des Steuergeräts, beispielsweise an einem Karosserieteil, nicht möglich. Ein weiteres Kriterium sind auch die erforderlichen Montagekräfte beim Verbinden der Baueinheit mit dem Steuergerät. Immer dann, wenn die Kontaktelemente nahezu gleichzeitig mit den Kontakteinheiten in Anlage gebracht werden, müssen die erforderlichen Vorspannkräfte sowohl auf die Kontaktelemente (Federelemente), als auch die Rastverbindung nahezu gleichzeitig aufgebracht werden, so dass relativ hohe Montagekräfte resultieren.

Um die Montagekräfte bei derartigen Verbindungsanordnungen zu reduzieren, ist es daher bekannt, zusätzliche Betätigungshebel einzusetzen, die die erforderlichen Montagekräfte beispielsweise auf ca. 100N reduzieren.

Aus der EP 1 672 972 A1 ist ebenfalls eine Verbindungsanordnung zwischen einem Steuergerät und einer mit dem Steuergerät verbundenen Baueinheit nach dem Oberbegriff des Anspruchs 1 bekannt.

Weiterhin ist es aus der JP 2000 156254 A bekannt, zur Ausbildung einer Verbindungsanordnung mit einem Schaltungsträger einen Befestigungsbügel vorzusehen, der zwei elastisch verformbare Befestigungsarme aufweist. An den Befestigungsarmen sind Fortsätze ausgebildet, die auf der dem Schaltungsträger zugewandten Seite mit gegengleichen Ausnehmungen des Schaltungsträgers zusammenwirken, um eine Rastverbindung auszubilden. Weiterhin weisen die beiden Befestigungsarme stiftartige Fortsätze auf, die in entsprechende Aufnahmen eines plattenförmigen Werkzeugelements eingreifen. Das Werkzeugelement dient dazu, beim Fügen des Befestigungsbügels mit dem Schaltungsträger die angesprochenen Elemente zueinander zu bewegen, wobei eine geradlinige Bewegung in Längsrichtung der Befestigungsarme ausgeführt wird. Dabei werden die Befestigungsarme elastisch aufgeweitet, bis diese in die gegengleichen Ausnehmungen des Schaltungsträgers gelangen und mit diesen verrasten. Auch bei dieser Verbindungsanordnung ist als nachteilhaft anzusehen, dass relativ hohe Montagekräfte erforderlich sind.

### Offenbarung der Erfindung

Ausgehend von dem dargestellten Stand der Technik liegt der Erfindung die Aufgabe zugrunde, eine Verbindungsanordnung zwischen einem Steuergerät und einer mit dem Steuergerät verbundenen Baueinheit zur elektrischen Kontaktierung des Steuergeräts nach dem Oberbegriff des Anspruchs 1 derart weiterzubilden, dass eine besonders einfache Verbindung geschaffen wird, bei der insbesondere die erforderlichen Montagekräfte trotz der einfachen Konstruktion relativ gering sind.

Diese Aufgabe wird erfindungsgemäß bei einer Verbindungsanordnung zwischen einem Steuergerät und einer mit dem Steuergerät verbundenen Baueinheit mit den Merkmalen des Anspruchs 1 dadurch gelöst, dass die Baueinheit einen Befestigungsbügel mit zwei Befestigungsarmen umfasst, dass die beiden Befestigungsarme mit jeweils einer Seite der Gehäuseeinheit mechanisch verbindbar sind, dass die beiden Befestigungsarme mit einem Verbindungsabschnitt miteinander verbunden sind, der das wenigstens eine Kontaktelement trägt, und dass der Befestigungsbügel um einer Schwenkachse gelagert ist, wobei die Schwenkebene des Befestigungsbügels zumindest im Wesentlichen parallel zu der Kontakteinheit verläuft, an der das Kontaktelement anlegbar ist.

Eine derartige Ausbildung der Baueinheit mit einem Befestigungsbügel mit zwei Befestigungsarmen ermöglicht es, die Montage des Befestigungsbügels zunächst mit einem Befestigungsarm zu starten, d.h., dass die erforderliche, relativ geringe Montagekraft lediglich an einem Befestigungsarm aufgebracht werden muss. Sobald der eine Befestigungsarm in seiner Schwenkachse verankert bzw. gelagert ist, kann durch Aufbringen einer weiteren, ebenfalls relativ geringen Montagekraft im Bereich des anderen Befestigungsarms der Schwenkbügel um seine Schwenkachse geschwenkt werden, bis der andere Befestigungsarm mit der entsprechenden Seite der Gehäuseeinheit verbunden ist.

Vorteilhafte Weiterbildungen der erfindungsgemäßen Verbindungsanordnung zwischen einem Steuergerät und einer mit dem Steuergerät verbundenen Baueinheit sind in den Unteransprüchen aufgeführt.

Ganz besonders bevorzugt ist eine konstruktive Ausbildung der Verbindungsanordnung, bei der das Kontaktelement in einer Montagestellung des Befestigungsbügels beabstandet zur Oberfläche der Kontakteinheit angeordnet ist, wobei zumindest in der Endlage, bei der die Befestigungsarme mit der Gehäuseeinheit verbunden sind, das Kontaktelement unter Vorspannung an der Oberfläche der Kontakteinheit anliegt. Eine derartige Ausbildung ermöglicht es, dass das Kontaktelement während der eigentlichen Montage nicht in Kontakt mit dem Schaltungsträger, insbesondere mit dessen Stirnfläche gelangt, so dass mechanische Beschädigungen oder Abrieb an der Kontakteinheit, dem Schaltungsträger sowie dem Kontaktelement vor Erreichen der Endstellung vermieden werden.

Um die Vorspannkraft zwischen dem Kontaktelement und der Kontakteinheit zur erzielen, ohne dass hierzu im Wesentlichen separate Bauteile erforderlich sind, wird vorgeschlagen, dass die Vorspannung zwischen dem Kontaktelement und der Kontakteinheit durch elastische Deformation des Kontaktelements gegen ein ortsfestes Anschlagelement erzeugbar ist. Insbesondere kann es sich bei dem ortsfesten Anschlagelement um eine Anschlagfläche an der Gehäuseeinheit in Form eines Anschlagstegs handeln. Da eine derartige Gehäuseeinheit Seitenwände bzw. Begrenzungen aufweist, lässt sich die Anschlagfläche somit ohne zusätzliche Kosten als entsprechende Seitenfläche bzw. Teil der Seitenfläche der Gehäuseeinheit ausbilden.

Um einen mechanischen Schutz sowie einen Schutz gegen Zutritt von Medien im Bereich der Kontaktelemente und Kontaktbereiche zu erzielen, ist es weiterhin bevorzugt vorgesehen, dass der Befestigungsbügel das Steuergerät bei montiertem Befestigungsbügel zumindest im Bereich der Kontakteinheit überdeckt.

Um die angesprochene Montage des Befestigungsbügels an dem Steuergerät zu ermöglichen, bei der der Befestigungsbügel zunächst mit einem Befestigungsarm an der Gehäuseeinheit verbunden wird und anschließend um die Schwenkachse verschwenkt wird, ohne dass hierzu ein besonders aufwändiger oder viel Bauraum benötigender Befestigungsbügel erforderlich ist, wird vorgeschlagen, dass wenigstens einer der Befestigungsarme elastisch deformierbar ausgebildet oder in einem Gelenk schwenkbar angeordnet ist.

In konkreter Ausgestaltung zur Realisierung der Schwenkachse wird vorgeschlagen, dass der eine Befestigungsarm oder eine Seite der Gehäuseeinheit einen Fortsatz aufweist, der formschlüssig unter Ausbildung der Schwenkachse in eine Aussparung der Seite der Gehäuseeinheit oder des Befestigungsarms eingreift, und dass der andere Befestigungsarm Mittel zur Ausbildung einer Rastverbindung zwischen dem Befestigungsarm und der Gehäuseeinheit aufweist. Eine derartige Ausbildung hat insbesondere den Vorteil, dass eine werkzeuglose Montage des Befestigungsbügels am Steuergerät ermöglicht wird, da der Befestigungsbügel bzw. die Befestigungsarme allein durch form- bzw. kraftschlüssige Verbindungen, ohne die Verwendung separater Befestigungselemente wie Schrauben oder ähnlichem, an dem Steuergerät befestigt werden können.

Eine weitere vorteilhafte Ausgestaltung, bei der eine relativ großflächige elektrische Kontaktierung der Kontakteinheiten mit den Kontaktelementen ermöglicht wird, sieht vor, dass die Oberfläche der Kontakteinheit eine gebogene Form aufweist, wobei die Form einen Teilkreisdurchmesser aufweist, der dem Abstand zwischen der Schwenkachse und dem der Kontakteinheit zugeordneten Federelement entspricht. Eine derartige Ausgestaltung ermöglicht es, dass während der Schwenkbewegung das Kontaktelement relativ frühzeitig mit der Kontakteinheit in Wirkverbindung gebracht werden kann.

In alternativer Ausgestaltung der beiden Befestigungsarme kann es vorgesehen sein, dass beide Befestigungsarme elastisch deformierbar ausgebildet sind und Mittel zur Ausbildung einer Rastverbindung zwischen dem jeweiligen Befestigungsarm und der Gehäuseeinheit aufweisen. Eine derartige Ausbildung ermöglicht es, zunächst eine erste Rastverbindung zwischen dem einen Befestigungsarm und dem Steuergerät herzustellen und anschließend durch Aufbringen einer Kraft an dem anderen Befestigungsarm die zweite Rastverbindung auszubilden, bei dem der andere Befestigungsarm mit dem Steuergerät bzw. der Gehäuseeinheit verrastet wird.

Zur Reduzierung der erforderlichen Montagekräfte kann es darüber hinaus vorgesehen sein, dass an wenigstens einem Befestigungsarm sowie der zugeordneten Seite der Gehäuseeinheit Montagemittel zur Verstärkung einer Montagekraft für den Befestigungsarm vorgesehen sind.

Weitere Vorteile, Merkmale und Einzelheiten der Erfindung ergeben sich aus der nachfolgenden Beschreibung bevorzugter Ausführungsbeispiele sowie anhand der Zeichnung.

Diese zeigt in:
- Fig. 1: in teilweise geschnittener Draufsicht eine Verbindungsanordnung zwischen einem Steuergerät und einer mit dem Steuergerät verbundenen Baueinheit in Form eines Kabelbaumsteckers,
- Fig. 2: einen Schnitt in der Ebene II-II der Fig. 1,
- Fig. 3: einen Teil der Anordnung der Fig. 1 zur Erläuterung der Kräfte während der Befestigung eines Befestigungsbügels an dem Steuergerät und
- Fig. 4 und Fig. 5: jeweils in vereinfachter Darstellung den Kontaktierungsvorgang der Baueinheit gemäß Fig. 1 während dessen Montage an dem Steuergerät, jeweils in vereinfachtem Längsschnitt.

Gleiche Elemente bzw. Elemente mit gleicher Funktion sind in den Figuren mit den gleichen Bezugsziffern versehen.

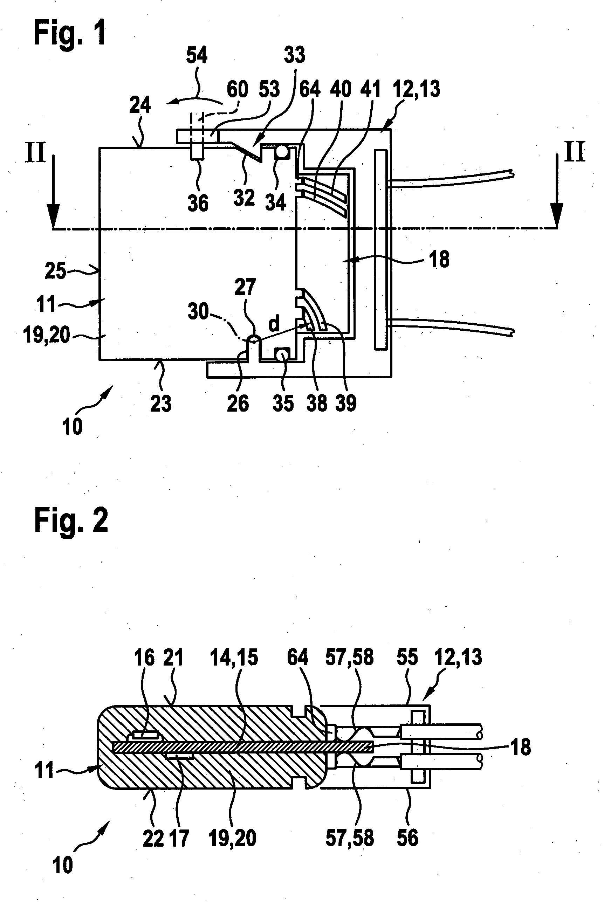

In den Fig. 1 und 2 ist eine erfindurigsgemäße Verbindungsanordnung 10 zwischen einem Steuergerät 11, wie es insbesondere in Kraftfahrzeugen Verwendung findet, und einer mit dem Steuergerät 11 verbundenen Baueinheit 12 zur elektrischen Kontaktierung des Steuergeräts 11 dargestellt. Bei der Baueinheit 12 handelt es sich insbesondere, jedoch nicht einschränkend, um den dem Steuergerät 11 zugewandten und mit diesem verbundenen Endbereich eines Kabelbaums des Kraftfahrzeugs in Form eines Kabelbaumsteckers 13.

Das Steuergerät 11 weist einen Schaltungsträger 14 in Form einer Leiterplatte 15 auf, auf der wenigstens eine mit der Baueinheit 12 kontaktierbare Schaltungseinheit, umfassend elektrische bzw. elektronische Bauteile 16, 17, angeordnet ist.

Ergänzend wird erwähnt, dass anstelle einer Leiterplatte 15 als Schaltungsträger 14 auch beliebige andere Schaltungsträger 14, z.B. in Form von Keramiksubstraten oder ähnlichem, vorgesehen sein können.

Der Schaltungsträger 14 ist bis auf einen Anschlussbereich 18 der Leiterplatte 15, der der elektrischen Kontaktierung durch die Baueinheit 12 dient, von einer aus Kunststoff bestehenden Schutzmasse 19 umgeben. Die Schutzmasse 19 besteht insbesondere, jedoch nicht einschränkend, aus einem harten Kunststoff, d.h., dass der Schaltungsträger 14 (mit Ausnahme des Anschlussbereichs 18) von der Schutzmasse 19 umgossen ist. Die Schutzmasse 19 bildet dadurch eine Gehäuseeinheit 20 aus, die im dargestellten Ausführungsbeispiel in etwa block- bzw. quaderförmig mit einer ebenen Oberseite 21, einer parallel dazu angeordneten Unterseite 22, zwei parallel zueinander angeordneten Seitenflächen 23, 24 sowie eine ebene Rückseite 25 umfasst. In der einen Seitenfläche 23 ist auf der dem Anschlussbereich 18 zugewandten Seite eine beispielhaft zylindrisch ausgebildete Aufnahme 26 in Form eines Lochs ausgebildet. Die Aufnahme 26 weist im dargestellten Ausführungsbeispiel einen gerundet ausgebildeten Grund 27 auf. Die Aufnahme 26 bildet senkrecht zur Zeichenebene der Figur 1 eine Schwenkachse 30 aus und dient der Befestigung der Baueinheit 12, wie nachfolgend noch näher erläutert wird.

Gegenüberliegend zur Aufnahme 26 ist in der anderen Seitenfläche 24 der Gehäuseeinheit 20 eine im Querschnitt dreiecksförmige Ausnehmung 32 als Bestandteil einer Rastverbindung 33 zwischen der Gehäuseeinheit 20 und der Baueinheit 12 ausgebildet. Weiterhin ist an den beiden Seitenflächen 23, 24, der Oberseite 21 und der Unterseite 22 eine an der Oberfläche der Gehäuseeinheit 12 ausgebildete, umlaufende Nut 34 zur Aufnahme eines Dichtungselements 35 ausgebildet, das bei an der Gehäuseeinheit 20 montierter Baueinheit 12 eine Abdichtung zwischen der Gehäuseeinheit 20 und der Baueinheit 12, insbesondere gegen das Eindringen von Medien bzw. Feuchtigkeit in Richtung zum Anschlussbereich 18, ausbildet. Zuletzt ist an der Seitenwand 24 auf der der Nut 34 abgewandten Seite der Ausnehmung 32 eine weitere Ausnehmung 36 ausgebildet, die der zeitweiligen Verankerung bzw. Aufnahme eines Montagehilfswerkzeugs 60 zur Befestigung der Baueinheit 12 an der Gehäuseeinheit 20 dient.

Die Aufnahme 26, die Ausnehmung 32, die Nut 34 sowie die weitere Ausnehmung 36 sind insbesondere durch eine entsprechende Gestaltung des Werkzeugs zum Ausbilden der Gehäuseeinheit 20 berücksichtigt, d.h., dass sie beim Ausbilden der Gehäuseeinheit 20 (z.B. Umspritzen des Schaltungsträgers 14 mit der Schutzmasse 19) ohne einen zusätzlichen Arbeitsschritt ausgebildet werden können.

Der Anschlussbereich 18 der Leiterplatte 15 bzw. des Schaltungsträgers 14 ist im dargestellten Ausführungsbeispiel vollständig frei von der Schutzmasse 19. Insbesondere erkennt man anhand der Darstellung der Fig. 1 auf der Oberseite der Leiterplatte 15 beispielhaft vier Kontakteinheiten 38 bis 41 in Form sogenannter Lands, die der elektrischen Kontaktierung der auf dem Schaltungsträger 14 angeordneten Schalteinheit dienen. Die Kontakteinheiten 38 bis 41 (wobei in der Praxis mehr als vier Kontakteinheiten 38 bis 41 vorgesehen sind) sind in Draufsicht jeweils gekrümmt ausgebildet, wobei der Krümmungsradius der Kontakteinheiten 38 bis 41 dem Teilkreisdurchmesser d entspricht, der sich aus dem Abstand zwischen der Schwenkachse 30 zu der jeweiligen Kontakteinheit 38 bis 41 ergibt. Weiterhin wird erwähnt, dass nicht nur auf der Oberseite der Leiterplatte 15 Kontakteinheiten 38 bis 41 vorgesehen sind, sondern ebenfalls auf der Unterseite der Leiterplatte 15, wobei die dort angeordneten (im einzelnen nicht dargestellten) Kontakteinheiten vorzugsweise fluchtend bzw. in Überdeckung mit den auf der Oberseite der Leiterplatte 15 angeordneten Kontakteinheiten 38 bis 41 angeordnet sind.

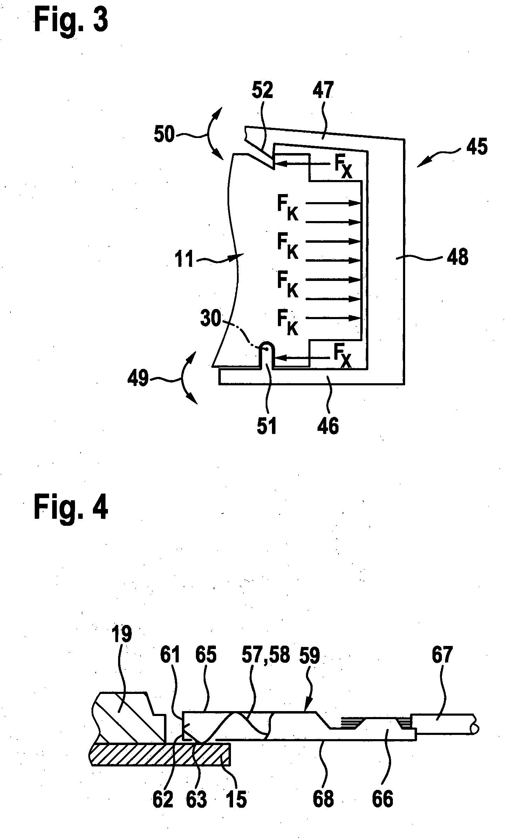

Die Baueinheit 12 ist als einstückiger Befestigungsbügel 45 mit zwei Befestigungsarmen 46, 47 sowie einem die beiden Befestigungsarme 46, 47 verbindenden Verbindungsabschnitt 48 ausgebildet. Insbesondere besteht der Befestigungsbügel 45 aus einem Duroplast, so dass dieser ähnliche Wärmeausdehnungseigenschaften bzw. einen ähnlichen Wärmeausdehnungskoeffizienten aufweist wie das Material der Schutzmasse 19, so dass mechanische Spannungen zwischen dem Steuergerät 11 und dem Befestigungsbügel 45 bei unterschiedlichen Temperaturen vermieden werden. Wie insbesondere anhand der Fig. 3 erkennbar ist, ist der Befestigungsbügel 45 in Draufsicht in etwa U-förmig ausgebildet. Zumindest die beiden Befestigungsarme 46, 47 bestehen aus einem elastischen Material bzw. weisen einen derartigen Querschnitt auf, dass die Befestigungsarme 46, 47 jeweils um einen gewissen Winkel in Richtung der Doppelpfeile 49, 50 elastisch schwenkbar angeordnet sind.

Der der Seitenfläche 23 zugeordnete eine Befestigungsarm 46 weist auf der dem anderen Befestigungsarm 47 zugewandten Seite einen Fortsatz 51 auf, der dazu ausgebildet ist, mit der Aufnahme 26 in der Seitenfläche 23 der Gehäuseeinheit 20 formschlüssig zusammenzuwirken, derart, dass der Befestigungsarm 46 um die Schwenkachse 30 schwenkbar ist. Demgegenüber weist der andere Befestigungsarm 47 einen im Querschnitt dreiecksförmig ausgebildeten Rasthaken 52 auf, der als Bestandteil der Rastverbindung 33 mit der Ausnehmung 32 bei an der Gehäuseeinheit 20 montierter Baueinheit 12 zusammenwirkt.

Der Abstand der beiden parallel zueinander angeordneten Befestigungsarme 46, 47 ist bevorzugt derart, dass in dem in der Fig. 1 erkennbaren montierten Zustand der Baueinheit 12 zwischen den Seitenflächen 23, 24 der Gehäuseeinheit 20 und den Befestigungsarmen 46, 47 lediglich noch ein geringer Spalt ausgebildet ist, der von dem Dichtungselement 35 verschlossen ist. Zusätzlich erkennt man anhand der Fig. 1 an dem Befestigungsarm 47 noch eine Durchgangsöffnung 53, die dazu dient, das bereits erwähnte, lediglich gestrichelt dargestellte Montagewerkzeug 60 durch den Befestigungsarm 47 hindurchzuführen und in die weitere Ausnehmung 36 einzuführen, um durch eine Hebelwirkung in Richtung des Pfeils 54 eine erhöhte Montagekraft auf den Befestigungsbügel 45 ausüben zu können.

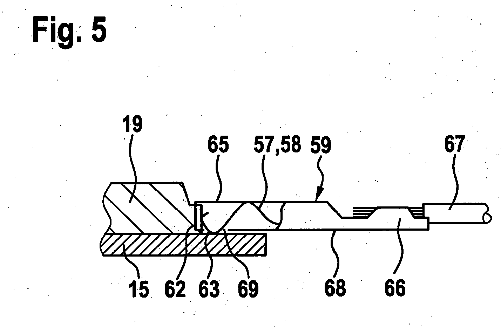

Der Verbindungsabschnitt 48 weist entsprechend der Fig. 2 eine geschlossene Oberseite 55 sowie Unterseite 56 auf, die den Anschlussbereich 18 abdecken bzw. schützen, und der bis über den Bereich des Dichtungselements 35 hinausragt. Weiterhin dient der Verbindungsabschnitt 48 der Aufnahme von insbesondere als Federelemente 57 ausgebildeten Kontaktelementen 58. Die entsprechend der Fig. 4 und 5 jeweils in einem Aufnahmeelement 59 zwischen einer oberen Wand 65 und einer unteren Wand 68 des Aufnahmeelements 59 angeordneten Kontaktelement 58 sind als gebogene Federelemente 57 derart ausgebildet, dass die vorderen Enden 61 zunächst gegen eine vordere Begrenzungswand 62 des Aufnahmeelements 59 anliegen, derart, dass ein der elektrischen Kontaktierung der jeweiligen Kontakteinheit 38 bis 41 dienender Kontaktabschnitt 63 oberhalb der unteren Wand 68 angeordnet ist. Weiterhin ist die untere Wand 68 des Aufnahmeelements 59 derart in Bezug zu dem Anschlussbereich bzw. den Kontakteinheiten 38 bis 41 angeordnet, dass die untere Wand 68 des Aufnahmeelements 59 zu den Kontakteinheiten 38 bis 41 mit Abstand verläuft. Wenn hingegen der Verbindungsabschnitt 48 gegen an der Gehäuseeinheit 20 ausgebildeten, als Anschlagflächen dienenden Anschlagstegen 64 anliegen, durchdringen die Anschlagstege 64 die Begrenzungswand 62 des Aufnahmeelements 59 in entsprechenden Schlitzen derart, dass die Anschlagstege 64 in Kontakt mit den Enden 61 gelangen und dabei die Federelemente 57 derart (elastisch) zusammendrücken, dass der jeweilige Kontaktabschnitt 63 aus einer Aussparung 69 der unteren Wand 68 herausragt und unter Federvorspannung in Kontakt mit dem jeweiligen Kontaktabschnitt 38 bis 41 gerät.

Anhand der Fig. 4 und 5 ist darüber hinaus erkennbar, dass der Befestigungsbügel 45 auf der der Gehäuseeinheit 20 abgewandten Seite Crimpverbindungen 66 aufweist, die die Kontaktelemente 58 jeweils mit einem Kabel 67 des Kabelbaums elektrisch verbinden.

Zur Montage des Befestigungsbügels 45 über die kraftschlüssige Verbindung zum Steuergerät 11 wird der Befestigungsbügel 45 zunächst lediglich mit seinem Fortsatz 51 am Befestigungsarm 46 in Wirkverbindung mit der Aufnahme 26 gebracht. Dazu ist es erforderlich, den Befestigungsarm 46 etwas (elastisch) aufzubiegen. Dabei ist es lediglich erforderlich, eine relativ geringe Montagekraft Fₓ aufzuwenden, die fluchtend zu dem Befestigungsarm 46 entsprechend der Darstellung der Fig. 3 verläuft. Insbesondere beträgt die Montagekraft Fₓ die Hälfte der benötigten Kraft, die als Reaktionskraft aus den Kontaktkräften Fₖ der einzelnen Federelemente 57 an den Kontakteinheiten 38 bis 41 resultiert. Anschließend wird der Befestigungsbügel 45 im Bereich des anderen Befestigungsarms 47 gegriffen und der andere Befestigungsarm 47 entlang der Seitenfläche 24 verschoben. Dies erfolgt ebenfalls mit einer relativ geringen Montagekraft Fₓ entsprechend der Darstellung der Fig. 3 in Höhe des anderen Befestigungsarms 47. Wesentlich dabei ist auch, dass die Federelemente 57 während des Großteils der Montage nicht in Kontakt mit dem aus der Schutzmasse 19 herausragenden Bereich der Leiterplatte 15 sind, so dass auch Beschädigungen an den Elementen ausgeschlossen sind. Die Bewegung des Befestigungsbügels 45 während der Montage entspricht im Wesentlichen einer Schwenkbewegung des Befestigungsbügels 45 um die Schwenkachse 30, wobei die Schwenkebene des Befestigungsbügels 45 senkrecht zur Schwenkachse 30 bzw. parallel zu den Kontakteinheiten 38 bis 41 verläuft und die Kontaktelemente 58 oberhalb der Oberflächen der Kontakteinheiten 38 bis 41 entlanggeführt werden. Die Montage der Baueinheit 12 an der Gehäuseeinheit 20 ist abgeschlossen, wenn der Rasthaken 52 in die Ausnehmung 32 der Seitenfläche 24 unter Ausbildung der Rastverbindung 33 einrastet. Dabei gelangen die Federelemente 57, wie oben beschrieben, erst kurz vor Ausbildung der Rastverbindung 33 in Wirkverbindung mit den Anschlagstegen 64 der Gehäuseeinheit 20, so dass die elektrische Kontaktierung der Kontaktabschnitte 38 bis 41 durch die Kontaktelemente 58 erfolgt.

Ergänzend wird erwähnt, dass in den Fig. 4 und 5 lediglich die der Oberseite der Leiterplatte 15 zugeordneten Federelemente 57 bzw. Kontaktelemente 58 dargestellt sind. Bei einer Anordnung von Kontaktäbschnitten 38 bis 41 sowohl an der Oberseite als auch an der Unterseite der Leiterplatte 15 weist der Befestigungsbügel 45 bzw. die Baueinheit 12 selbstverständlich weitere, symmetrische zu den Federelementen 57 angeordnete weitere Kontaktelemente 58 auf, die der Kontaktierung der Kontaktabschnitte 38 bis 41 an der Unterseite der Leiterplatte 15 dienen.

Die soweit beschriebene Verbindungsanordnung 10 kann in vielfältiger Art und Weise abgewandelt bzw. modifiziert werden, ohne vom Erfindungsgedanken abzuweichen. So ist es insbesondere auch denkbar, auch den Befestigungsarm 46 in Analogie zum Befestigungsarm 47 auszubilden, das heißt mit einer Rastverbindung 33 auszustatten. In diesem Fall wird die Schwenkachse 30 durch die Rastverbindung 33 selbst ausgebildet. Auch kann der Rasthaken 52 eine andere Form bzw. einen anderen Querschnitt aufweisen.

## Patentansprüche

1. Verbindungsanordnung (10) zwischen einem Steuergerät (11) und einer mit dem Steuergerät (11) verbundenen Baueinheit (12) zur elektrischen Kontaktierung des Steuergeräts (11), wobei das Steuergerät (11) eine Gehäuseeinheit (20) aufweist, die aus einer Schutzmasse (19) besteht, und die einen Schaltungsträger (14) zumindest bereichsweise umgibt, mit wenigstens einer auf dem Schaltungsträger (14) angeordneten Schaltungseinheit und mit wenigstens einer Kontakteinheit (38 bis 41) für die Kontaktierung durch die Baueinheit (12), wobei die Gehäuseeinheit (20) im Bereich der wenigstens einen Kontakteinheit (38 bis 41) zumindest bereichsweise frei von der Schutzmasse (19) ist, wobei die Baueinheit (12) wenigstens ein Kontaktelement (58), vorzugsweise in Form eines Federelements (57) aufweist, das bei an dem Steuergerät (11) montierter Baueinheit (12) in elektrisch leitendem Kontakt mit der wenigstens einen Kontakteinheit (38 bis 41) ist, und wobei die mechanische Verbindung zwischen dem Steuergerät (11) und der Baueinheit (12) durch eine kraftschlüssige Verbindung erfolgt,
**dadurch gekennzeichnet,**
**dass** die Baueinheit (12) einen Befestigungsbügel (45) mit zwei Befestigungsarmen (46, 47) umfasst, dass die beiden Befestigungsarme (46, 47) mit jeweils einer Seite (23, 24) der Gehäuseeinheit (20) mechanisch verbindbar sind, dass die beiden Befestigungsarme (46, 47) mit einem Verbindungsabschnitt (48) miteinander verbunden sind, der das wenigstens eine Kontaktelement (58) trägt, dass der Befestigungsbügel (45) zum Kontaktieren des wenigstens einen Kontaktelements (58) mit der wenigstens einen Kontakteinheit (38 bis 41) in einer Schwenkachse (30) gelagert ist und dass der eine Befestigungsarm (46) oder die eine Seite (23) der Gehäuseeinheit (20) einen Fortsatz (51) aufweist, der formschlüssig unter Ausbildung der Schwenkachse (30) in eine Aufnahme (26) an der Seite (23) der Gehäuseeinheit (20) oder des Befestigungsarms (46) eingreift, wobei die Schwenkebene des Befestigungsbügels (45) parallel zu der Kontakteinheit (38 bis 41) verläuft, an der das Kontaktelement (58) anlegbar ist.

2. Verbindungsanordnung nach Anspruch 1,
**dadurch gekennzeichnet,**
**dass** das Kontaktelement (58) in einer Montagestellung des Befestigungsbügels (45) beabstandet zur Oberfläche der Kontakteinheit (38 bis 41) angeordnet ist, und dass zumindest in der Endlage, bei der die Befestigungsarme (46, 47) mit der Gehäuseeinheit (20) verbunden sind, das Kontaktelement (58) unter Vorspannung an der Kontakteinheit (38 bis 41) anliegt.

3. Verbindungsanordnung nach Anspruch 2,
**dadurch gekennzeichnet,**
**dass** die Vorspannung zwischen dem Kontaktelement (58) und der Kontakteinheit (38 bis 41) durch elastische Deformation des Kontaktelements (58) gegen ein ortsfestes Anschlagelement (64) erzeugbar ist.

4. Verbindungsanordnung nach Anspruch 3,
**dadurch gekennzeichnet,**
**dass** das Anschlagelement (64) als Anschlagsteg an der Gehäuseeinheit (20) ausgebildet ist.

5. Verbindungsanordnung nach einem der Ansprüche 1 bis 4,
**dadurch gekennzeichnet,**
**dass** der Befestigungsbügel (45) das Steuergerät (11) bei montiertem Befestigungsbügel (45) zumindest im Bereich der Kontakteinheit (38 bis 41) überdeckt.

6. Verbindungsanordnung nach einem der Ansprüche 1 bis 5,
**dadurch gekennzeichnet,**
**dass** wenigstens einer der Befestigungsarme (46, 47) elastisch deformierbar ausgebildet oder in einem Gelenk schwenkbar angeordnet ist.

7. Verbindungsanordnung nach einem der Ansprüche 1 bis 6,
**dadurch gekennzeichnet**,
der andere Befestigungsarm (47) Mittel (52) zur Ausbildung einer Rastverbindung (33) zwischen dem Befestigungsarm (47) und der Gehäuseeinheit (20) aufweist.

8. Verbindungsanordnung nach Anspruch 6 oder 7,
**dadurch gekennzeichnet,**
**dass** die Kontakteinheit (38 bis 41) eine gebogene Form aufweist, wobei die Form einen Teilkreisdurchmesser (d) aufweist, der dem Abstand zwischen der Schwenkachse (30) und dem der Kontakteinheit (38 bis 41) zugeordneten Federelement (57) entspricht.

9. Verbindungsanordnung nach einem der Ansprüche 1 bis 5,
**dadurch gekennzeichnet,**
**dass** beide Befestigungsarme (46, 47) elastisch deformierbar ausgebildet sind und beide Befestigungsarme (46, 47) Mittel (52) zur Ausbildung einer Rastverbindung (33) zwischen dem jeweiligen Befestigungsarm (46, 47) und der Gehäuseeinheit (20) aufweisen.

10. Verbindungsanordnung nach einem der Ansprüche 7 bis 9,
**dadurch gekennzeichnet,**
**dass** an wenigstens einem Befestigungsarm (46, 47) sowie der zugeordneten Seite (23, 24) der Gehäuseeinheit (20) Montagemittel (36, 53) zur Verstärkung einer Montagekraft für den Befestigungsarm (46, 47) vorgesehen sind.

## Claims

1. Connecting arrangement (10) between a control device (11) and a structural unit (12), which is connected to the control device (11), for making electrical contact with the control device (11), wherein the control device (11) has a housing unit (20) which consists of a protective compound (19) and which surrounds a circuit carrier (14) at least in regions, comprising at least one circuit unit which is arranged on the circuit carrier (14), and comprising at least one contact unit (38 to 41) for contact to be made by the structural unit (12), wherein the housing unit (20) is free of the protective compound (19) at least in regions in the region of the at least one contact unit (38 to 41), wherein the structural unit (12) has at least one contact element (58), preferably in the form of a spring element (57) which, when the structural unit (12) is fitted to the control device (11), is in electrically conductive contact with the at least one contact unit (38 to 41), and wherein the mechanical connection between the control device (11) and the structural unit (12) is established by a force-fitting connection,
**characterized**
**in that** the structural unit (12) comprises a fastening clip (45) with two fastening arms (46, 47), in that the two fastening arms (46, 47) can be mechanically connected to in each case one side (23, 24) of the housing unit (20), in that the two fastening arms (46, 47) are connected to one another by a connecting section (48) which carries the at least one contact element (58), and in that the fastening clip (45) for the at least one contact unit (38 to 41) to make contact with the at least one contact element (58) is mounted in a pivot axis (30), and in that the one fastening arm (46) or the one side (23) of the housing unit (20) has a projection (51) which engages into a receptacle (26) on the side (23) of the housing unit (20) or of the fastening arm (46) in an interlocking manner so as to form the pivot axis (30), wherein the pivot plane of the fastening clip (45) runs parallel to the contact unit (38 to 41) against which the contact element (58) can be placed.

2. Connecting arrangement according to Claim 1,
**characterized**
**in that** the contact element (58) is arranged at a distance from the surface of the contact unit (38 to 41) in a mounted position of the fastening clip (45), and in that the contact element (58) bears against the contact unit (38 to 41) under prestress at least in the end position in which the fastening arms (46, 47) are connected to the housing unit (20).

3. Connecting arrangement according to Claim 2,
**characterized**
**in that** the prestress between the contact element (58) and the contact unit (38 to 41) can be generated by elastic deformation of the contact element (58) against a stationary stop element (64).

4. Connecting arrangement according to Claim 3,
**characterized**
**in that** the stop element (64) is in the form of a stop web on the housing unit (20).

5. Connecting arrangement according to one of Claims 1 to 4,
**characterized**
**in that** the fastening clip (45) covers the control unit (11) at least in the region of the contact unit (38 to 41) when the fastening clip (45) is mounted.

6. Connecting arrangement according to one of Claims 1 to 5,
**characterized**
**in that** at least one of the fastening arms (46, 47) is of elastically deformable design or is arranged in a pivotable manner in a joint.

7. Connecting arrangement according to one of Claims 1 to 6,
**characterized**
**in that** the other fastening arm (47) has means (52) for forming a latching connection (33) between the fastening arm (47) and the housing unit (20).

8. Connecting arrangement according to Claim 6 or 7,
**characterized**
**in that** the contact unit (38 to 41) has a bent shape, wherein the shape has a pitch circle diameter (d) which corresponds to the distance between the pivot axis (30) and the spring element (57) which is associated with the contact unit (38 to 41).

9. Connecting arrangement according to one of Claims 1 to 5,
**characterized**
**in that** the two fastening arms (46, 47) are of elastically deformable design, and the two fastening arms (46, 47) have means (52) for forming a latching connection (33) between the respective fastening arm (46, 47) and the housing unit (20).

10. Connecting arrangement according to one of Claims 7 to 9,
**characterized**
**in that** mounting means (36, 53) for reinforcing a mounting force for the fastening arm (46, 47) are provided on at least one fastening arm (46, 47) and also the associated side (23, 24) of the housing unit (20).

## Revendications

1. Ensemble de liaison (10) entre un appareil de commande (11) et une unité modulaire (12) reliée à l'appareil de commande (11) pour la mise en contact électrique de l'appareil de commande (11), l'appareil de commande (11) présentant une unité de boîtier (20) qui se compose d'une masse de protection (19) et qui entoure au moins par zones un support de circuit (14), avec au moins une unité de circuit disposée sur le support de circuit (14) et avec au moins une unité de contact (38 à 41) pour la mise en contact par l'unité modulaire (12), l'unité de boîtier (20) étant, dans la zone de l'unité de contact (38 à 41) au moins au nombre de un, dépourvue de la masse de protection (19)au moins par zones, l'unité modulaire (12) présentant au moins un élément de contact (58), de préférence sous la forme d'un élément à ressort (57), qui, quand l'unité modulaire (12) est montée sur l'appareil de commande (11), est en contact électriquement conducteur avec l'unité de contact (38 à 41) au moins au nombre de un, et la liaison mécanique entre l'appareil de commande (11) et l'unité modulaire (12) s'effectuant par une liaison à liaison de force,
**caractérisé en ce que**
l'unité modulaire (12) comprend un étrier de fixation (45) avec deux bras de fixation (46, 47), **en ce que** les deux bras de fixation (46, 47) peuvent être reliés mécaniquement à respectivement un côté (23, 24) de l'unité de boîtier (20), **en ce que** les deux bras de fixation (46, 47) sont raccordés l'un à l'autre avec un tronçon de liaison (48) qui porte l'élément de contact (58) au moins au nombre de un, **en ce que** l'étrier de fixation (45) est supporté dans un axe de pivotement (30) pour la mise en contact de l'élément de contact (58) au moins au nombre de un avec l'unité de contact (38 à 41) au moins au nombre de un, et **en ce qu'**un bras de fixation (46) ou un côté (23) de l'unité de boîtier (20) présente un prolongement (51) qui engrène par liaison de forme, en formant l'axe de pivotement (30), dans un logement (26) sur le côté (23) de l'unité de boîtier (20) ou du bras de fixation (46), le plan de pivotement de l'étrier de fixation (45) étant parallèle à l'unité de contact (38 à 41) contre laquelle l'élément de contact (58) peut être appliqué.

2. Ensemble de liaison selon la revendication 1,
**caractérisé en ce que**,
dans une position de montage de l'étrier de fixation (45), l'élément de contact (58) est disposé à distance de la surface de l'unité de contact (38 à 41), et **en ce que**, au moins dans l'emplacement final dans lequel les bras de fixation (46, 47) sont raccordés à l'unité de boîtier (20), l'élément de contact (58) est adjacent à l'unité de contact (38 à 41) avec une pré-tension.

3. Ensemble de liaison selon la revendication 2,
**caractérisé en ce que**
la pré-tension entre l'élément de contact (58) et l'unité de contact (38 à 41) peut être produite par une déformation élastique de l'élément de contact (58) contre un élément de butée (64) stationnaire.

4. Ensemble de liaison selon la revendication 3,
**caractérisé en ce que**
l'élément de butée (64) est constitué en tant que barrette de butée sur l'unité de boîtier (20).

5. Ensemble de liaison selon l'une des revendications 1 à 4,
**caractérisé en ce que**,
au moins dans la zone de l'unité de contact (38 à 41), l'étrier de fixation (45) recouvre l'appareil de commande (11) quand l'étrier de fixation (45) est monté.

6. Ensemble de liaison selon l'une des revendications 1 à 5,
**caractérisé en ce**
**qu'**au moins un des bras de fixation (46, 47) est constitué de façon élastiquement déformable ou est disposé de façon pivotante dans une articulation.

7. Ensemble de liaison selon l'une des revendications 1 à 6,
**caractérisé en ce que**
l'autre bras de fixation (47) présente des moyens (52) pour la constitution d'une liaison par encliquetage (33) entre le bras de fixation (47) et l'unité de boîtier (20).

8. Ensemble de liaison selon la revendication 6 ou 7,
**caractérisé en ce que**
l'unité de contact (38 à 41) présente une forme courbée, la forme présentant un diamètre primitif de référence (d) qui correspond à la distance entre l'axe de pivotement (30) et l'élément à ressort (57) affecté à l'unité de contact (38 à 41).

9. Ensemble de liaison selon l'une des revendications 1 à 5,
**caractérisé en ce que**
les deux bras de fixation (46, 47) sont constitués de façon élastiquement déformable et les deux bras de fixation (46, 47) présentent des moyens (52) pour la constitution d'une liaison par encliquetage (33) entre le bras de fixation (46, 47) respectif et l'unité de boîtier (20).

10. Ensemble de liaison selon l'une des revendications 7 à 9,
**caractérisé en ce que**,
sur au moins un bras de fixation (46, 47) ainsi que sur le côté (23, 24) affecté de l'unité de boîtier (20), il est prévu des moyens de montage (36, 53) pour l'amplification de la force de montage pour le bras de fixation (46, 47).
